# EUROPÄISCHE PATENTSCHRIFT

(11) **EP 3 819 162 B1**
(45) Veröffentlichungstag und Bekanntmachung des Hinweises auf die Patenterteilung: **07.09.2022**
(21) Anmeldenummer: 19208302.0
(22) Anmeldetag: 11.11.2019
(51) Int. Cl.: B60M 5/00, G01R 31/54, B61L 27/00

(54) **BAHNENERGIEVERSORGUNGSSYSTEM UND VERFAHREN ZUR ÜBERWACHUNG DER INTEGRITÄT VON MINDESTENS EINEM RÜCKANSCHLUSSLEITER EINER RÜCKLEITUNG FÜR DEN BAHNSTROM**
TRACTION ENERGY SUPPLY SYSTEM AND METHOD FOR MONITORING THE INTEGRITY OF AT LEAST ONE CONDUCTOR OF A RETURN LINE FOR THE TRACTION ENERGY
SYSTÈME D'ALIMENTATION ÉLECTRIQUE FERROVIAIRE ET PROCÉDÉ DE SURVEILLANCE DE L'INTÉGRITÉ D'AU MOINS UN CONDUCTEUR DE RACCORDEMENT DE RETOUR D'UNE CONNECTION DE RETOUR POUR LE COURANT DE TRACTION

(43) Veröffentlichungstag der Anmeldung: 12.05.2021
(73) Patentinhaber: Rail Power Systems GmbH, 81373 München (DE)
(72) Erfinder: ZYNOVCHENKO, Andriy, 63067 Offenbach (DE)
(74) Vertreter: Oppermann, Frank

(56) Entgegenhaltungen:
- EP-A2- 2 862 744
- WO-A1-2018/154170
- DD-A1- 278 994
- DE-B3-102017 007 252

## Beschreibung

Die Erfindung betrifft ein Bahnenergieversorgungssystem für Gleichstrombahnen und ein Verfahren zur Überwachung der Integrität von mindestens einem Rückleitungsanschlussleiter einer Rückleitung für den Bahnstrom einer Bahnenergieversorgungsanlage für Gleichstrombahnen.

In Bahnanlagen mit elektrisch betriebenen Schienenfahrzeugen wird der Bahnrückstrom über die Rückleitung zurück zur Traktionsenergiequelle eines Unterwerks geführt. Die Rückleitung umfasst nach der Norm DIN EN 50122-1:2017 alle Leiter, die den vorgesehenen Pfad für den Bahnrückstrom bilden. Zu diesen Leitern können neben der Schienenrückleitung (Fahrschienen) und den parallel zur Schienenführung verlegten Rückleitern, die in wiederholenden Abständen mit den Fahrschienen verbunden sind, auch die Rückleitungsanschlussleiter gehören, mit denen die Fahrschienen oder die anderen Teile der Rückleitung mit dem Unterwerk verbunden werden (DIN EN 50122-1:2017).

Die auf dem Gleisbett verlegten Fahrschienen der Gleichstrombahnen weisen eine elektrische Ableitung zum Erdreich auf, die zwecks Minderung der unerwünschten Streustromeffekte, beispielsweise Korrosion, zwar möglichst klein gehalten werden soll, jedoch nicht vollständig eliminiert werden kann. Das Unterwerk eines Bahnenergieversorgungssystems weist eine Erdungsanlage auf, welche zur Vermeidung des Streustromflusses mit der Rückleitung nicht permanent verbunden sein sollte.

Für einen sicheren und zuverlässigen Bahnbetrieb muss die Integrität der Rückleitung sichergestellt werden. Die Rückleitungsanschlussleiter als Teil der Rückleitung sind unterwerksseitig an die Rückleitersammelschiene im Unterwerk und streckenseitig an die Schienenrückleitung angeschlossen. Im Allgemeinen ist eine Mehrzahl von Rückleitungsanschlussleitern vorhanden. Als Rückleitungsanschlussleiter werden üblicherweise Kabel verwendet. Diese werden zwischen der Bahnstrecke und dem Unterwerk verlegt. Auf Grund von großen Querschnitten von beispielsweise 500 mm² und einem hohen Gehalt an hochwertigem Buntmetall, Kupfer oder Aluminium, sind diese Kabel diebstahlgefährdet, insbesondere wenn keine durchgehende Erdverlegung der Kabel möglich ist oder wenn der Zugang zur überirdisch ausgeführten streckenseitigen Kabelanschlussstellen an die Schienenrückleitung durch Unberechtigte erlangt werden kann. Neben dem Verlust von hochwertigem Buntmetall und aufwendigen Reparaturarbeiten kann ein Kabeldiebstahl noch die nachfolgend beschriebenen Folgen haben.

Die Trennung von nur einem von mehreren Rückleitungsanschlussleitern hat in der Praxis zwar keine Konsequenzen, führt aber dazu, dass die nach dem Stand der Technik geforderte Redundanz von N+1 nicht mehr vorliegt. N ist dabei die Anzahl der Rückleitungsanschlussleiter, die für eine Strombelastung von 100% dimensioniert ist.

Ein Ausfall von mehreren Rückleitungsanschlussleitern führt zur Erhöhung des Widerstandes der Rückleitung. Bei Gleichstrombahnen sind mögliche Konsequenzen die Erhöhung des Schienenpotentials und ggf. die Entstehung gefährlicher Berührungsspannungen, ein häufiges Ansprechen von Spannungsbegrenzungseinrichtungen, als VLD bekannt, wenn diese installiert sind, mit ihrer Überlastung und Ausfall als möglicher Folge sowie ein erhöhtes Streustromrisiko.

Durch die Trennung von mehreren Rückleitungsanschlussleitern nimmt die Strombelastung der verbliebenen Leiter proportional zu. Bleibt der Fehlerzustand unbemerkt, ist eine Überlastung der verbliebenen Rückleitungsanschlussleiter mit nachfolgendem Ausfall je nach ihrer Stromtragfähigkeit und Streckenauslastung wahrscheinlich. Eine solche Weiterentwicklung des Fehlers mit anschließendem Ausfall sämtlicher Rückleitungsanschlussleiter kann zu unplanmäßigen Einschränkungen im Zugbetrieb bis hin zu seiner kompletten Betriebseinstellung führen. Es ist daher wichtig, den Zustand einzelner Rückleitungsanschlussleiter zu überwachen. Um auf den Schaden, zum Beispiel in Folge eines Kabeldiebstahls, schnellstmöglich reagieren zu können, im Hinblick sowohl auf betriebliche Gegenmaßnahmen als auch auf eine Tatverfolgung, ist eine zyklische Überwachung sowohl während des Bahnbetriebs als auch in den Betriebsruhezeiten vorteilhaft.

Aus der EP 2 862 744 A2 ist ein Verfahren zur Überwachung eines parallel zu den Fahrschienen verlegten Rückleiters eines Bahngleises bekannt, bei dem die in den Fahrschienen und in dem Rückleiterkabel fließenden Ströme erfasst werden und die Summe der Ströme in den Schienen mit dem Rückstrom im Rückleiter verglichen wird. Wenn die Differenz der Betriebsströme einen vorgegebenen Wert überschreitet, wird ein Signal erzeugt, das auf eine Unterbrechung des Rückleiterkabels hinweisen soll. Der Nachteil des Verfahrens liegt darin, dass die Kabelüberwachung nur in den Betriebszeiten unter Bahnrückstromfluss möglich ist. Ein Kabeldiebstahl oder Kabelbruch kann in den betriebslosen Ruhezeiten mit dem obigen Verfahren aber nicht erkannt werden.

Die DE 10 2014 111 734 A1 und DE 10 2013 005 901 A1 beschreiben Überwachungsansätze für ein Stromkabel. Die Arbeitsprinzipien setzen die Verwendung von speziellen Stromkabeln voraus. Nachteilig hierbei ist, dass der Einsatz von speziellen Kabeln nur bei der Neuerrichtung einer Anlage in Frage kommt. Eine Neuverlegung der Spezialkabel als Rückleitungsanschlussleiter in bereits errichteten und im Betrieb befindlichen Unterwerken erweist sich aber unter wirtschaftlichen Gesichtspunkten im Allgemeinen als nicht vertretbar.

Aus der US 9 417 268 B2 ist eine Prüfzange bekannt, mit der man den Erdungswiderstand einer elektrischen Anlage messen kann. In der Praxis finden die bekannten Prüfzangen zur Überprüfung der Integrität des Erdungssystems in Unterwerken Verwendung. Die Prüfzangen sind für eine periodische Prüfung einzelner Leiter geeignet und bestimmt. Eine dauerhafte Überwachung eines Leiters ist in der Praxis mit einer Prüfzange nicht möglich. Nachteilig ist auch, dass mit einer Prüfzange nicht mehrere Leiter gleichzeitig überwacht werden können. Darüber hinaus ist eine Messung mit einer Prüfzange dann nicht möglich, wenn die zu prüfenden Leiter den Betriebsstrom führen. Dies ist durch die Auslegung der Magnetkreise der Prüfzangen bedingt, welche im Allgemeinen bei hohen Leiterströmen, beispielsweise bei Leiterströmen größer als 40 A, in Sättigung gehen und daher eine Prüfmessung bei Betriebsstrom nicht zulassen. Daher ist eine Überwachung eines Leiters mit der Prüfzange während der Bahnbetriebszeiten, d.h. beim fließenden Bahnrückstrom, nicht möglich.

Aus DE 10 2017 007 252 B3 ist eine Überwachungsvorrichtung und ein Verfahren zur kontinuierlichen und vom Bahnrückstromfluss unabhängigen Überwachung der Integrität der Rückleitungsanschlussleiter bekannt. Das Arbeitsprinzip beruht auf der Einspeisung eines Überwachungsstroms mit einer bestimmten Frequenz in parallel geschaltete Rückleitungsanschlussleiter mit nachfolgender Erfassung des Überwachungsstroms in sämtlichen Rückleitungsanschlussleitern mittels induktiver Sensoren. Auf einen Verlust eines Rückleitungsanschlussleiters oder auf einen fehlerhaften Rückleitungsanschlussleiter, beispielsweise aufgrund eines Kabeldiebstahls oder Kabelbruchs, wird dann geschlossen, wenn mit einem Sensor, der einem Rückleitungsanschlussleiter zugeordnet ist, der Überwachungsstrom mit der vorgegebenen Frequenz nicht erfasst wird. Die Einspeisung des Überwachungsstroms erfolgt über einen induktiven Stromwandler, der dem betreffenden Rückleitungsanschlussleiter zugeordnet ist. Nachteilig hierbei ist, dass eine praktische Realisierung des einspeisenden induktiven Stromwandlers, welcher den in der DE 10 2017 007 252 B3 gestellten Anforderungen genügt, sehr aufwendig ist, insbesondere hinsichtlich der Anforderungen an ein lineares Übertragungsverhalten des Wandlers bei den hohen Traktionsströmen während des Bahnbetriebs.

Der vorliegenden Erfindung liegt die Aufgabe zugrunde, ein Bahnenergieversorgungssystem für Gleichstrombahnen mit einer Überwachungsvorrichtung bereitzustellen, die eine gleichzeitige Überwachung von einem oder mehreren Rückleitungsanschlussleitern einer Rückleitung für den Bahnrückstrom sowohl in den Bahnbetriebszeiten als auch in den betriebslosen Ruhezeiten ermöglicht, um einen Kabeldiebstahl oder Kabelbruch eines Rückleitungsanschlussleiters feststellen und melden zu können. Die Überwachung soll zyklisch in relativ kurzen Zeitabständen erfolgen können. Insbesondere liegt der Erfindung die Aufgabe zugrunde, ein Bahnenergieversorgungssystem für Gleichstrombahnen bereitzustellen, dessen Überwachungsvorrichtung mit marktüblichen Einrichtungen zum Einspeisen, Erfassen und Auswerten eines Überwachungsstroms ohne größeren technischen Aufwand relativ einfach realisierbar ist. Darüber hinaus ist eine Aufgabe der Erfindung, ein Verfahren anzugeben, das eine gleichzeitige Überwachung von einem oder mehreren Rückleitungsanschlussleitern sowohl in den Bahnbetriebszeiten als auch den Ruhezeiten erlaubt. Insbesondere ist die Aufgabe der Erfindung ein Verfahren anzugeben, das ohne größeren technischen Aufwand relativ einfach durchgeführt werden kann.

Die Lösung dieser Aufgaben erfolgt erfindungsgemäß mit den Merkmalen der unabhängigen Patentansprüche. Die abhängigen Ansprüche betreffen vorteilhafte Ausführungsformen der Erfindung.

Mit dem erfindungsgemäßen Bahnenergieversorgungssystem können gleichzeitig ein oder mehrere Rückleitungsanschlussleiter sowohl in den Bahnbetriebszeiten als auch den Ruhezeiten überwacht werden. Die Überwachungsvorrichtung des Bahnenergieversorgungssystems erlaubt die Überwachung der Integrität von als Kabel ausgeführten Rückleitungsanschlussleitern, die Teil der Rückleitung für den Bahnstrom sind. Die Rückleitungsanschlussleiter als Teil der Rückleitung können die Traktionsenergiequelle des Unterwerks mit der Schienenrückleitung (Fahrschienen) elektrisch verbinden. Die Überwachung einer Mehrzahl von Rückleitungsanschlussleitern kann zyklisch in festgelegten relativ kurzen Zeitabständen automatisiert erfolgen.

Die Überwachungsvorrichtung verfügt über eine Wechselstrom-Einspeiseeinrichtung, die derart ausgebildet ist, dass ein Überwachungs-Wechselstrom derart eingespeist wird, dass der Überwachungs-Wechselstrom in dem mindestens einen Rückleitungsanschlussleiter fließt, mindestens einen Sensor zur Erfassung eines in dem mindestens einen Rückleitungsanschlussleiter fließenden Stroms und eine das Signal des mindestens einen Sensors auswertende und die Wechselstrom-Einspeiseeinrichtung ansteuernde Auswerte-und Steuereinrichtung.

Die Stromeinspeise-Einrichtung zur Einspeisung eines Überwachungsstroms kann über eine Wechselstromquelle oder eine Wechselspannungsquelle verfügen, die einen periodischen, beispielsweise einen sinusförmigen oder rechteckförmigen Wechselstrom, erzeugt. Der Wechselstrom kann aber auch jede andere beliebige periodische Wellenform haben. Zur Reduzierung der Störeinflüsse sollte der Wechselstrom eine Grundfrequenz haben, die nicht den Frequenzen von anderen Signalen oder einem Mehrfachen dieser Frequenzen entspricht, die im Umfeld der Rückleitungsanschlussleiter zu erwarten sind, d.h. die Frequenz sollte von den in der Energie- und Bahntechnik üblicherweise verwendeten Frequenzen oder einem Mehrfachen davon abweichen. Vorzugsweise sollte die Frequenz möglichst niedrig, jedoch mit induktiven Sensoren messbar sein. In der Praxis kann für den Überwachungsstrom beispielsweise eine Frequenz von 10 Hz verwendet werden.

Die Auswerte- und Steuereinrichtung ist derart konfiguriert, dass überprüfbar ist, ob mit dem Sensor zur Erfassung eines in dem mindestens einen Rückleitungsanschlussleiter fließenden Stroms Transienten eines in dem mindestens einen Rückleitungsanschlussleiter fließenden Betriebsstroms, die größer als ein vorgegebener Wert sind, erfasst werden, oder überprüfbar ist, ob ein in dem mindestens einen Rückleitungsanschlussleiter fließender Überwachungs-Wechselstrom einen vorgegebenen Grenzwert überschreitet, wobei auf einen Verlust eines Rückleitungsanschlussleiters oder einen fehlerhaften Rückleitungsanschlussleiter geschlossen wird, wenn weder Transienten des Betriebsstroms noch der Überwachungs-Wechselstrom einen vorgegebenen Grenzwert überschreiten.

Die den Rückleitungsanschlussleitern zugeordneten Sensoren erfassen also die in den Rückleitungsanschlussleitern fließenden Ströme, d.h. den Betriebsstrom oder den Überwachungsstrom. Der Betriebsstrom ist grundsätzlich ein Gleichstrom, der sich aber in den Betriebszeiten aufgrund des Beschleunigens und Abbremsens der Bahnen in der Höhe verändern kann. Diese Stromschwankungen werden auch als Transienten des Betriebsstroms oder den transienten Anteil des Betriebsstroms bezeichnet. Der Überwachungsstrom ist ein Wechselstrom mit einer vorgegebenen Frequenz. Die Sensoren, die den Rückleitungsanschlussleitern zugeordnet sind, können die Transienten des Betriebsstroms oder den Wechselstrom erfassen, bzw. die Auswerte- und Steuereinrichtung kann die Signale der Sensoren derart auswerten, dass die Transienten des Betriebsstroms oder der Wechselstrom erfasst werden.

Eine bevorzugte Ausführungsform des Bahnenergieversorgungssystems sieht vor, dass die Auswerte- und Steuereinrichtung eine Einrichtung zur Zu- und Abschaltung der Stromeinspeise-Einrichtung aufweist, wobei die Auswerte- und Steuereinrichtung derart konfiguriert ist, dass in einem ersten Schritt bei ausgeschalteter Stromeinspeise-Einrichtung überprüft wird, ob Transienten eines in dem mindestens einen Rückleitungsanschlussleiter fließenden Betriebsstroms einen vorgegebenen Grenzwert überschreiten. Auf eine Integrität des mindestens einen Rückleitungsanschlussleiters wird geschlossen, wenn mit dem Sensor Transienten eines Betriebsstroms, die größer als ein vorgegebener Grenzwert sind, erfasst werden. Werden Transienten eines Betriebsstroms mit dem Sensor nicht erfasst, kann aber noch nicht auf einen Verlust eines Rückleitungsanschlussleiters oder einen fehlerhaften Rückleitungsanschlussleiter geschlossen werden, da ein Betriebsstrom nicht zu jeder Zeit fließen muss.

Die Auswerte- und Steuereinrichtung weist vorzugsweise ein Zeitglied auf, wobei die Auswerte- und Steuereinrichtung derart konfiguriert ist, dass in einem zweiten Schritt bei zugeschalteter Stromeinspeise-Einrichtung überprüft wird, ob ein in dem mindestens einen Rückleitungsanschlussleiter fließender Überwachungs-Wechselstrom einen vorgegebenen Grenzwert überschreitet, wenn nach Ablauf des Zeitglieds in dem ersten Schritt bei abgeschalteter Stromeinspeise-Einrichtung Transienten eines in dem mindestens einen Rückleitungsanschlussleiter fließenden Betriebsstroms einen vorgegebenen Grenzwert nicht überschritten haben.

Die Auswerte- und Steuereinrichtung kann derart konfiguriert sein, dass auf eine Integrität des mindestens einen Rückleitungsanschlussleiters geschlossen wird, wenn der in dem mindestens einen Rückleitungsanschlussleiter fließende Überwachungs-Wechselstrom einen vorgegebenen Grenzwert überschreitet. Die Auswerte- und Steuereinrichtung kann auch derart konfiguriert sein, dass auf einen Verlust eines Rückleitungsanschlussleiters oder einen fehlerhaften Rückleitungsanschlussleiter geschlossen wird, wenn der Überwachungs-Wechselstrom einen vorgegebenen Grenzwert nicht überschreitet.

Die Auswerte- und Steuereinrichtung ist vorzugsweise derart konfiguriert, dass die Stromeinspeise-Einrichtung (2) wieder abgeschaltet und bei abgeschalteter Stromeinspeise-Einrichtung (2) wieder überprüft wird, ob Transienten eines Betriebsstroms erfasst werden, wenn der in dem mindestens einen Rückleitungsanschlussleiter fließende Überwachungs-Wechselstrom einen vorgegebenen Grenzwert überschreitet.

Die Funktionsweise der Überwachungsvorrichtung wird nachfolgend nochmals zusammengefasst.

Während der Betriebszeiten kann auf die Integrität des betreffenden Rückleitungsanschlussleiters dann geschlossen werden, wenn mit einem Sensor, der dem Rückleitungsanschlussleiter zugeordnet ist, die Transienten des Betriebsstroms erfasst werden. Die Auswerte- und Steuereinrichtung braucht die Strom-Einspeiseeinrichtung nicht zuzuschalten, wenn die Integrität der Rückleitungsanschlussleiter anhand der Transienten des Betriebsstroms festgestellt werden kann. Können in einem oder mehreren Rückleitungsanschlussleitern keine Transienten des Betriebsstroms über eine vorgegebene Zeitdauer festgestellt werden, so kann dies zwei Gründe haben:
- Grund 1: fehlende Transienten im Betriebsstrom auf Grund des nicht vorhandenen Bahnbetriebes, zum Beispiel infolge der Betriebsruhe oder einer Verkehrsstörung.
- Grund 2: fehlende Transienten im Betriebsstrom auf Grund eines Kabelverlustes oder -fehlers.

Zwecks Unterscheidung zwischen den möglichen Gründen kann die Stromeinspeise-Einrichtung durch die Auswerte- und Steuereinrichtung zugeschaltet und nach einer kurzen Zeit wieder abgeschaltet werden. Im zugeschalteten Zustand wird der Überwachungs-Wechselstrom eingespeist. Kann der Überwachungs-Wechselstrom mit einem Sensor, der einem Rückleitungsanschlussleiter zugeordnet ist, festgestellt werden, wird auf die Integrität des betreffenden Rückleitungsanschlussleiters geschlossen. Werden dagegen kein Überwachungsstrom und weiterhin keine Transienten der Betriebsströme festgestellt, so wird auf einen Kabelfehler oder einen Kabelverlust, beispielsweise infolge eines Kabeldiebstahls, geschlossen.

Die Überprüfung der Integrität der Rückleitungsanschlussleiter durch Zuschaltung der Stromeinspeise-Einrichtung kann zyklisch erfolgen, wobei die Zykluszeit einige Minuten lang sein kann. In der Praxis kann eine Zykluszeit von beispielsweise 15 oder 20 Minuten verwendet werden.

Die Dauer der Zuschaltung der Stromeinspeise-Einrichtung in jedem Prüfzyklus sollte möglichst kurz sein, um die Korrosionsauswirkungen durch den Überwachungsstrom möglichst gering zu halten. Jedoch sollte die Zuschaltdauer ausreichend lang sein, um den Überwachungsstrom in den Rückleitungsanschlussleitern mit Hilfe der Sensoren erfassen zu können. In der Praxis sollte die Zuschaltdauer mehrere Perioden des Überwachungsstroms enthalten, zum Beispiel 10 Perioden. Bei einer Frequenz des Überwachungsstroms von 10 Hz würde die Zuschaltdauer somit 1 Sekunde betragen.

Eine weitere bevorzugte Ausführungsform sieht vor, dass die Auswerte- und Steuereinrichtung eine Einrichtung zur Erzeugung eines Steuer- oder Meldesignals aufweist, wobei die Auswerte- und Steuereinrichtung derart ausgebildet ist, dass ein Steuer- oder Meldesignal erzeugt wird, wenn weder Transienten des Betriebsstroms noch der Überwachungs-Wechselstrom einen vorgegebenen Grenzwert überschreiten. Es ist aber auch möglich ein Steuer- oder Meldesignal für den umgekehrten Fall zu erzeugen, dass die Transienten des Betriebsstroms oder der Überwachungsstrom erfasst werden. Das Steuer- oder Meldesignal kann an eine vorhandene Leit- oder Überwachungszentrale übertragen oder auf andere Weise weiterverwertet werden.

Für die praktische Realisierung der Überwachungsvorrichtung ist von besonderer Bedeutung, dass der Überwachungs-Wechselstrom nicht mittels einer induktiven Einspeisevorrichtung direkt in den betreffenden Rückleitungsanschlussleiter induktiv eingespeist wird, wie in der DE 10 2017 007 252 B3 beschrieben ist. Aufgrund der hohen Traktionsströme des Bahnbetriebs können Magnetkreise der einspeisenden induktiven Stromwandler in Sättigung gehen, so dass eine Stromeinspeisung nicht mehr möglich ist. Dieser Effekt kann bis zu mehrere Tage anhalten. Abhilfe könnte nur mit einer relativ aufwendigen Entmagnetisierungsvorrichtung geleistet werden, was zu vermeiden gilt.

Die Unterwerke des Bahnenergieversorgungssystems für Gleichstrombahnen verfügen üblicherweise über eine Erdungsschiene, die mit einer Erdungsanlage des Unterwerks elektrisch verbunden ist, so dass eine elektrische Ableitung zum Erdreich geschaffen wird. Die Schienenrückleitung hat trotz der Isolation noch eine elektrische Ableitung zum Erdreich.

Eine bevorzugte Ausführungsform sieht vor, dass die Wechselstromeinspeise-Einrichtung zwischen der Rückleitersammelschiene und der Erdungsschiene der Energieversorgungsanlage geschaltet ist, wobei ein erster Anschluss der Stromeinspeise-Einrichtung mit der Rückleitersammelschiene und ein zweiter Anschluss der Stromeinspeise-Einrichtung mit der Erdungsschiene elektrisch verbunden ist, so dass ein Überwachungs-Wechselstrom in einem Stromkreis fließt, welcher die Erdungsschiene, die Erdungsanlage und deren Ableitung zum Erdreich, die Schienenrückleitung und deren Ableitung zum Erdreich, den mindestens einen Rückleitungsanschlussleiter und die Rückleitersammelschiene umfasst. Die Wechselstromeinspeise-Einrichtung kann eine Wechselstromquelle oder eine Wechselspannungsquelle aufweisen, welche zwischen der Rückleitersammelschiene und Erdungsschiene des Unterwerkes geschaltet ist. Mit der galvanischen Einspeisung des Überwachungsstroms können die oben genannten Probleme einer Sättigung der Magnetkerne induktiver Stromwandler nicht auftreten, so dass die technische Realisierung wesentlich vereinfacht wird.

Die Wechselstrom-Einspeiseeinrichtung kann in Reihe mit einer Diode, die auch als Streustromsperrdiode bezeichnet werden kann, geschaltet werden. Bei dieser Ausführungsform ist die Streustromsperrdiode in Sperrrichtung des durch den elektrischen Bahnbetrieb bedingten Streustroms geschaltet. Die Streustromsperrdiode verhindert den Fluss des Streustroms über die Erdungsanlage des Unterwerkes sowie über die Wechselstrom-Einspeiseeinrichtung.

Bei einer besonders bevorzugten Ausführungsform wird eine Gleichstromkomponente in Durchlassrichtung der Streustromsperrdiode dem Überwachungs-Wechselstrom überlagert, so dass die gesamte Wellenform des resultierenden Überwachungsstroms im Durchlassbereich der Diode liegt.

Die Sensoren zur Erfassung eines in dem mindestens einen Rückleitungsanschlussleiter fließenden Stroms sind vorzugsweise induktive Sensoren ohne Magnetkern, mit denen sich die Wechselstromanteile erfassen lassen. Als besonders vorteilhaft haben sich Rogowski-Spulen erwiesen.

Das erfindungsgemäße Verfahren zeichnet sich durch die folgenden Verfahrensschritte aus:
Einspeisen eines Überwachungs-Wechselstroms in einen Stromkreis, der mindestens einen Rückanschlussleiters umfasst,
Vorsehen mindestens eines Sensors zur Erfassung eines in dem mindestens einen Rückleitungsanschlussleiter fließenden Stroms,
Überprüfen, ob Transienten eines in dem mindestens einen Rückleitungsanschlussleiter fließenden Betriebsstroms einen vorgegebenen Grenzwert überschreiten, und
Überprüfen, ob ein in dem mindestens einen Rückleitungsanschlussleiter fließender Überwachungs-Wechselstrom einen vorgegebenen Grenzwert überschreitet,
wobei auf einen Verlust eines Rückleitungsanschlussleiters oder einen fehlerhaften Rückleitungsanschlussleiter geschlossen wird, wenn weder Transienten des Betriebsstroms noch der Überwachungs-Wechselstrom einen vorgegebenen Grenzwert überschreiten.

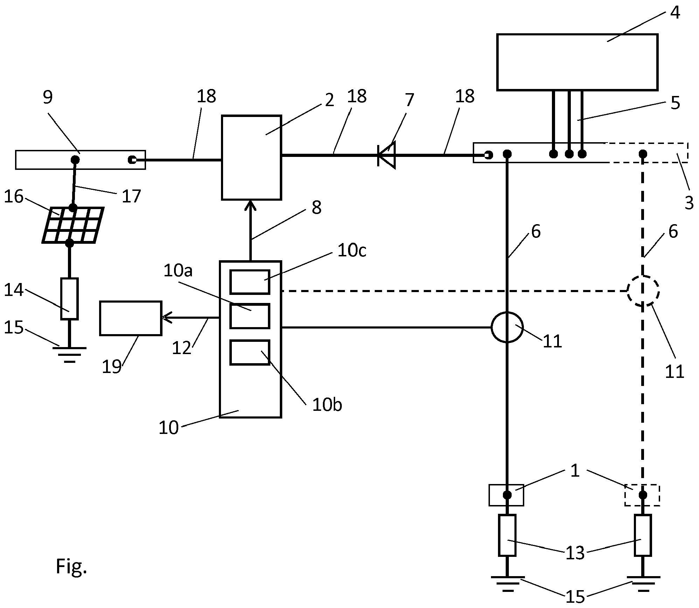

Im Folgenden wird ein Ausführungsbeispiel der Erfindung unter Bezugnahme auf die einzige Figur näher erläutert. Die Figur zeigt das erfindungsgemäße Bahnenergieversorgungssystem mit einem Teil der Rückleitung für den Bahnrückstrom sowie die Überwachungsvorrichtung in vereinfachter Darstellung.

In der Figur ist ein Teil der Rückleitung gezeigt. Dieser Teil der Rückleitung weist eine unterwerkseitige Rückleitersammelschiene 3 auf, an der zu einer Traktionsenergiequelle 4, beispielsweise ein Traktionsgleichrichter, führende Leiter 5 angeschlossen sind. Darüber hinaus weist dieser Teil der Rückleitung eine Mehrzahl von Rückleitungsanschlussleitern 6 auf, welche zwischen der unterwerkseitigen Rückleitersammelschiene 3 und der Schienenrückleitung 1 (Fahrschienen) angeschlossen sind. Bei dem vorliegenden Ausführungsbeispiel weist die Rückleitung zwei Rückleitungsanschlussleiter 6 auf, von denen in der Figur ein Rückleitungsanschlussleiter in gestrichelten Linien dargestellt ist, um anzudeuten, dass mindestens einer, üblicherweise jedoch mehrere Rückleitungsanschlussleiter vorgesehen sind. Es können aber auch mehr als zwei Rückleitungsanschlussleiter vorgesehen sein. Für eine korrekte Funktion der erfindungsgemäßen Vorrichtung ist mindestens ein Rückleitungsanschlussleiter erforderlich. Die Rückleitungsanschlussleiter 6 können zwischen der Rückleitersammelschiene 3 und der streckenseitigen Schienenrückleitung 1 auch über eine oder mehrere in der Figur nicht dargestellte streckenseitige Rückleitersammelschienen geschaltet sein.

Wenn ein Schienenfahrzeug über seinen Stromabnehmer den Betriebsstrom bezieht, fließt der Rückstrom über die Schienenrückleitung 1 und über die Rückleitungsanschlussleiter 6 zu der unterwerkseitigen Rückleitersammelschiene 3 und von der unterwerkseitigen Rückleitersammelschiene 3 über die Leiter 5 zurück zu der Traktionsenergiequelle 4. Die Schienenrückleitung 1 weist baubedingt eine elektrische Ableitung 13 zum Erdreich 15 auf.

Das Unterwerk verfügt über eine Erdungsschiene 9, die bei den Gleichstrombahnen mit der Rückleitersammelschiene 3 zwecks Verringerung der Streuströme üblicherweise nicht verbunden ist. Darüber hinaus umfasst das Unterwerk eine Erdungsanlage 16, die üblicherweise als Maschenerder ausgeführt ist. Die Erdungsanlage 16 des Unterwerkes stellt eine aus Betriebssicherheitsgründen nach dem Stand der Technik erforderliche elektrische Ableitung 14 zum Erdreich 15 sicher und ist über eine Erdungsleitung 17, beispielsweise ein Kabel, an die Erdungsschiene 9 angeschlossen.

Das Bahnenergieversorgungssystem verfügt über einen Stromkreis, der eine Verbindungsleitung 18 zwischen der Erdungsschiene 9 und der Rückleitersammelschiene 3, die Erdungsschiene 9, die Erdungsleitung 17, die Erdungsanlage 16 mit ihrer Ableitung 14 zum Erdreich 15, das Erdreich 15, die Ableitung 13 der Schienenrückleitung 13 zum Erdreich 15, einen oder mehrere Rückleitungsanschlussleiter 6 und die Rückleitersammelschiene 3 gebildet wird. In die Verbindungsleitung 18 zwischen der Erdungsschiene 9 und der Rückleitersammelschiene 3 ist eine Diode (Streustromsperrdiode) 7 und eine Stromeinspeise-Einrichtung 2 geschaltet. Die Streustromsperrdiode 7 ist polaritätsmäßig in Sperrrichtung des durch den elektrischen Zugbetrieb bedingten Streustroms angeschlossen. Die Streustromsperrdiode 7 verhindert den Fluss des Streustroms über die Erdungsanlage 16 des Unterwerkes sowie über die Stromeinspeise-Einrichtung 2. Das Ausführungsbeispiel zeigt die bevorzugte Durchlassrichtung der Streustromsperrdiode 7 für das Fahrleitungsspeisekonzept mit PlusPotential anliegend an der Fahrleitung und Minus-Potential anliegend an der Rückleitung.

Die Wechselstromeinspeise-Einrichtung 2, mit der ein Wechselstrom in den oben bezeichneten Stromkreis galvanisch eingespeist wird, kann eine Wechselstrom- oder Wechselspannungsquelle sein, beispielsweise ein Frequenzumrichter, Frequenzwechselrichter oder Frequenzgenerator mit oder ohne Verstärker. Der Wechselstrom hat eine vorgegebene Frequenz, die bei dem vorliegenden Ausführungsbeispiel 10 Hz ist. Diese Frequenz unterscheidet sich von den Frequenzen, die Wechselströme im Umfeld der Rückleitungsanschlussleiter üblicherweise haben. Weiterhin liegt die Frequenz im messbaren Frequenzbereich von den einzelnen Rückleitungsanschlussleitern 6 zugeordneten induktiven Sensoren 11. Darüber hinaus ist die Wechselstromeinspeise-Einrichtung 2 vorzugsweise derart ausgebildet, dass der Wechselstrom mit einer Gleichstromkomponente in die Durchlassrichtung der Streustromsperrdiode überlagert ist, so dass die gesamte Wellenform des resultierenden Stroms im Durchlassbereich der Streustromsperrdiode liegt.

Darüber hinaus verfügt die Überwachungsvorrichtung über eine Auswerte- und Steuereinrichtung 10, die die Signale der den einzelnen Rückleitungsanschlussleitern 6 zugeordneten induktiven Sensoren 11 empfängt. Die Auswerte- und Steuereinrichtung 10 weist eine Steuereinheit 10a auf, die über eine Steuerleitung oder Übertragungsstrecke 8 die Wechselstromeinspeise-Einrichtung 2 angesteuert, d.h. zu- oder abschaltet. Die induktiven Sensoren 11 sind vorzugsweise Luftspulen, die keinen ferromagnetischen Kern haben, insbesondere Rogowski-Spulen.

Die Auswerte- und Steuereinrichtung 10 ist derart ausgebildet, dass überprüft wird, ob mit den induktiven Sensoren 11, die den Rückleitungsanschlussleitern 6 zugeordnet sind, die Transienten des Bahnbetriebsstroms während des Zugbetriebes oder der Überwachungs-Wechselstrom in den Zeiten des ruhenden Zugbetriebes erfasst werden. Auf einen Verlust oder einen fehlerhaften Rückleitungsanschlussleiter 6 schließt die Auswerte- und Steuereinrichtung 10 dann, wenn mit dem Sensor 11, der dem betreffenden Rückleitungsanschlussleiter zugeordnet ist, weder die Transienten des Zugbetriebsstroms noch der Überwachungsstrom, die größer als ein vorgegebener Grenzwert sind, erfasst werden. Die Auswerte- und Steuereinrichtung 10 kann die Integrität nur eines Rückleitungsanschlussleiters oder mehrerer Rückleitungsanschlussleiter überwachen, wobei für die Überwachung mehrerer Rückleitungsanschlussleiter die Signale der den jeweiligen Rückleitungsanschlussleitern zugeordneten Sensoren 11 ausgewertet werden. Dabei ist von Vorteil, dass der von der Wechselstromeinspeise-Einrichtung 2 eingespeiste Überwachungs-Wechselstrom durch sämtliche Rückleitungsanschlussleiter fließt.

Die Auswerte- und Steuereinrichtung 10 kann ein oder mehrere Filter aufweisen, um die elektromagnetisch eingekoppelten Störbeeinflussungen der Sensorsignale zu unterdrücken. Die Auswerte- und Steuereinrichtung 10 weist den einzelnen Sensoren 11 zugeordnete Komparatoren auf, die den mit den Sensoren 11 gemessenen Überwachungs-Wechselstrom oder den transienten Anteil des Betriebsstromes mit einem Grenzwert vergleichen. Wenn der in dem jeweiligen Rückleitungsanschlussleiter 6 gemessene Wechselstrom kleiner als der Grenzwert ist, wird darauf geschlossen, dass dieser Rückleitungsanschlussleiter nicht mehr vorhanden oder defekt ist.

Darüber hinaus weist die Auswerte- und Steuereinrichtung 10 eine Einrichtung 10c auf, die derart ausgebildet ist, dass in dem Fall des Verlustes oder Defektes von einem oder mehreren Rückleitungsanschlussleitern 6 ein Steuer- oder Meldesignal erzeugt wird, welches einen Kabelverlust oder -defekt signalisiert. Das Steuer- oder Meldesignal kann über eine Signalleitung oder Übertragungsstrecke 12 an eine Leit- oder

Überwachungszentrale 19 weitergeleitet und dort weiterverwertet werden, beispielsweise zur Anzeige auf einem Bildschirm oder zur Erzeugung eines akustischen Signals, um einen Alarm zu geben. Die Auswerte- und Steuereinrichtung 10 weist weiterhin ein Zeitglied 10b auf, das eine bestimmte Verzögerungszeit vorgibt.

Die Auswerte- und Steuereinrichtung 10 kann eine Einrichtung sein, die analoge oder digitale Schaltkreise oder deren Kombination umfassen kann. Beispielsweise kann die Auswerte- und Steuereinrichtung 10 einen allgemeinen Prozessor, einen digitalen Signalprozessor (DSP) zur kontinuierlichen Bearbeitung digitaler Signale, einen Mikroprozessor, eine anwendungsspezifische integrierte Schaltung (ASIC), einen aus Logikelementen bestehenden integrierten Schaltkreis (FPGA) oder andere integrierte Schaltkreise (IC) oder Hardware-Komponenten aufweisen. Auf den Hardware-Komponenten kann ein Datenverarbeitungsprogramm (Software) laufen, um die einzelnen Komponenten derart anzusteuern, so dass die einzelnen Verfahrensschritte durchgeführt werden.

Die Auswerte- und Steuereinrichtung 10 ist derart konfiguriert, dass die folgenden Verfahrensschritte durchgeführt werden:

### Schritt 1

Bei abgeschalteter Wechselstrom-Einspeiseeinrichtung 2 wird mit den Sensoren 11 überwacht, ob Transienten des Betriebsstroms, die größer als ein Grenzwert sind, in den Rückleitungsanschlussleitern 6 erfasst werden. Ist dies der Fall, wird auf die Integrität der Rückleitungsanschlussleiter geschlossen und der Überwachungsablauf in Schritt 1 beginnt von neuem. Können dagegen keine Transienten des Betriebsstroms in einem oder in mehreren Rückleitungsanschlussleitern während der durch das Zeitglied 10b vorgegebenen Zeit festgestellt werden, wird die Überwachung mit zeitlich parallel ablaufenden Schritten 2 und 3 fortgesetzt.

### Schritt 2

Zwecks Unterscheidung, ob Transienten des Betriebsstroms in den Rückleitungsanschlussleitern 6 im Schritt 1 durch den fehlenden Bahnbetrieb oder in Folge eines Kabelverlusts oder -bruchs nicht festgestellt werden konnten, wird die Wechselstrom-Einspeiseeinrichtung 2 zwecks Einspeisung des Überwachungs-Wechselstroms durch die Steuereinheit 10a der Auswerte- und Steuereinrichtung 10 zugeschaltet und nach einer kurzen Zeit, die mindestens eine, jedoch vorzugsweise mehrere Perioden des Überwachungsstroms umfasst, wieder abgeschaltet.

### Schritt 3

Während der Zuschaltung der Auswerte- und Steuereinrichtung 10 im Schritt 2 wird mit den Sensoren 11 überwacht, ob die Anteile des Überwachungsstroms, die größer als ein Grenzwert sind, in den betreffenden Rückleitungsanschlussleitern 6 erfasst werden. Ist dies der Fall, wird auf das Vorliegen der Integrität der betreffenden Rückleitungsanschlussleiter 6 geschlossen und der Überwachungsablauf wird mit Schritt 1 fortgesetzt. Anderenfalls wird mit Schritt 4 fortgesetzt.

### Schritt 4

Können keine den Grenzwert überschreitenden Anteile des Überwachungsstroms in den betreffenden Rückleitungsanschlussleitern 6 festgestellt werden, wird auf Kabelverlust oder -bruch geschlossen. Die Einrichtung 10c erzeugt ein Steuer- oder Meldesignal, welches den Verlust oder Defekt von einem oder mehreren oder allen Rückleitungsanschlussleitern 6 signalisiert.

Die oben beschriebenen Routinen können für einzelne Rückleitungsanschlussleiter oder mehrere Rückleitungsanschlussleiter oder sämtliche Rückleitungsanschlussleiter einer Mehrzahl von Rückleitungsanschlussleitern 6 durchgeführt werden.

## Patentansprüche

1. Bahnenergieversorgungssystem für Gleichstrombahnen aufweisend
ein Unterwerk, das eine Traktionsenergiequelle (4) und eine mit der Traktionsenergiequelle (4) elektrisch verbundene Rückleitersammelschiene (3) umfasst,
eine Rückleitung für den Bahnrückstrom, die mindestens einen die Rückleitersammelschiene (3) mit einer Schienenrückleitung (1) elektrisch verbindenden Rückleitungsanschlussleiter (6) umfasst, und
eine Überwachungsvorrichtung zur Überwachung der Integrität von mindestens einem Rückleitungsanschlussleiter (6),
wobei die Überwachungsvorrichtung aufweist:
eine Stromeinspeise-Einrichtung (2), die derart ausgebildet ist, dass ein Überwachungs-Wechselstrom eingespeist wird, der in dem mindestens einen Rückleitungsanschlussleiter (6) fließt,
mindestens einen Sensor (11) zur Erfassung eines in dem mindestens einen Rückleitungsanschlussleiter (6) fließenden Stroms und eine das Signal des mindestens einen Sensors auswertende und die Stromeinspeise-Einrichtung (2) ansteuernde Auswerte- und Steuereinrichtung (10),
**dadurch gekennzeichnet, dass**
die Auswerte- und Steuereinrichtung derart konfiguriert ist, dass mit dem mindestens einen Sensor (11) überprüfbar ist, ob Transienten eines in dem mindestens einen Rückleitungsanschlussleiter (6) fließenden Betriebsstrom einen vorgegebenen Grenzwert überschreiten, oder mit dem mindestens einen Sensor (11) überprüfbar ist,
ob ein in dem mindestens einen Rückleitungsanschlussleiter (6) fließender Überwachungs-Wechselstrom einen vorgegebenen Grenzwert überschreitet, wobei auf einen Verlust eines Rückleitungsanschlussleiters (6) oder einen fehlerhaften Rückleitungsanschlussleiter geschlossen wird, wenn weder Transienten des Betriebsstroms noch der Überwachungs-Wechselstrom einen vorgegebenen Grenzwert überschreiten.

2. Bahnenergieversorgungssystem nach Anspruch 1, **dadurch gekennzeichnet, dass** die
Auswerte- und Steuereinrichtung (10) eine Steuereinheit (10a) zur Zu- und Abschaltung der Stromeinspeise-Einrichtung (2) aufweist, wobei die Auswerte- und Steuereinrichtung (10) derart konfiguriert ist, dass in einem ersten Schritt bei abgeschalteter Stromeinspeise-Einrichtung (2) überprüft wird, ob Transienten eines in dem mindestens einen Rückleitungsanschlussleiter (6) fließenden Betriebsstroms einen vorgegebenen Grenzwert überschreiten, wobei auf eine Integrität des mindestens einen Rückleitungsanschlussleiters geschlossen wird, wenn mit dem Sensor (11) Transienten eines Betriebsstroms, die größer als ein vorgegebener Grenzwert sind, erfasst werden.

3. Bahnenergieversorgungssystem nach Anspruch 2, **dadurch gekennzeichnet, dass** die Auswerte- und Steuereinrichtung (10) ein Zeitglied (10b) aufweist, wobei die Auswerte- und Steuereinrichtung (10) derart konfiguriert ist, dass in einem zweiten Schritt bei zugeschalteter Stromeinspeise-Einrichtung (2) überprüft wird, ob ein in dem mindestens einen Rückleitungsanschlussleiter (6) fließender Überwachungs-Wechselstrom einen vorgegebenen Grenzwert überschreitet, wenn nach Ablauf des Zeitglieds in dem ersten Schritt bei ausgeschalteter Stromeinspeise-Einrichtung (2) Transienten eines in dem mindestens einen Rückleitungsanschlussleiter (6) fließenden Betriebsstroms den vorgegebenen Grenzwert nicht überschreiten.

4. Bahnenergieversorgungssystem nach Anspruch 3, **dadurch gekennzeichnet, dass** die Auswerte- und Steuereinrichtung (10) derart konfiguriert ist, dass auf eine Integrität des mindestens einen Rückleitungsanschlussleiters (6) geschlossen wird, wenn der in dem Rückleitungsanschlussleiter (6) fließende Überwachungs-Wechselstrom einen vorgegebenen Grenzwert überschreitet.

5. Bahnenergieversorgungssystem nach Anspruch 4, **dadurch gekennzeichnet, dass** die Auswerte- und Steuereinrichtung (10) derart konfiguriert ist, dass die Stromeinspeise-Einrichtung (2) wieder abgeschaltet und bei abgeschalteter Stromeinspeise-Einrichtung (2) wieder überprüft wird, ob Transienten eines Betriebsstroms einen vorgegebenen Grenzwert überschreiten, wenn der in dem mindestens einen Rückleitungsanschlussleiter (6) fließende Überwachungs-Wechselstrom den vorgegebenen Grenzwert überschreitet.

6. Bahnenergieversorgungssystem nach Anspruch 3, **dadurch gekennzeichnet, dass** die Auswerte- und Steuereinrichtung (10) derart konfiguriert ist, dass auf einen Verlust des mindestens einen Rückleitungsanschlussleiters oder einen fehlerhaften Rückleitungsanschlussleiter geschlossen wird, wenn der in dem Rückleitungsanschlussleiter (6) fließende Überwachungs-Wechselstrom einen vorgegebenen Grenzwert nicht überschreitet.

7. Bahnenergieversorgungssystem nach einem der Ansprüche 1 bis 6, **dadurch gekennzeichnet, dass** die Auswerte- und Steuereinrichtung (10) eine Einrichtung (10c) zur Erzeugung eines Steuer- oder Meldesignals aufweist, wobei die Auswerte- und Steuereinrichtung (10) derart ausgebildet ist, dass ein Steuer- oder Meldesignal erzeugt wird, wenn weder Transienten des Betriebsstroms einen vorgegebenen Grenzwert überschreiten noch der Überwachungs-Wechselstrom einen vorgegebenen Grenzwert überschreitet.

8. Bahnenergieversorgungssystem nach einem der Ansprüche 1 bis 7, **dadurch gekennzeichnet, dass** das Unterwerk eine Erdungsschiene (9), die mit einer Erdungsanlage (16) elektrisch verbunden ist, umfasst, so dass eine elektrische Ableitung (14) zum Erdreich (15) geschaffen wird, wobei die Schienenrückleitung (1) eine elektrische Ableitung (13) zum Erdreich (15) hat, und dass die Stromeinspeise-Einrichtung (2) zwischen der Rückleitersammelschiene (3) und der Erdungsschiene (9) der Energieversorgungsanlage geschaltet ist, wobei ein erster Anschluss der Stromeinspeise-Einrichtung (2) mit der Rückleitersammelschiene (3) und ein zweiter Anschluss der Stromeinspeise-Einrichtung (2) mit der Erdungsschiene (9) elektrisch verbunden ist, so dass ein Überwachungs-Wechselstrom in einem Stromkreis fließt, welcher die Erdungsschiene (9), die Erdungsanlage (16) und deren Ableitung (14) zum Erdreich (15), die Schienenrückleitung (1) und deren Ableitung (13) zum Erdreich (15), den mindestens einen Rückleitungsanschlussleiter (6) und die Rückleitersammelschiene (3) umfasst.

9. Bahnenergieversorgungssystem nach Anspruch 8, **dadurch gekennzeichnet, dass** der Stromeinspeise-Einrichtung (2) eine Diode (7) vor- oder nachgeschaltet ist.

10. Bahnenergieversorgungssystem nach einem der Ansprüche 1 bis 9, **dadurch gekennzeichnet, dass** die Sensoren (11) zur Erfassung eines in dem mindestens einen Rückleitungsanschlussleiter (6) fließenden Stroms induktive Sensoren ohne Magnetkern sind.

11. Verfahren zur Überwachung der Integrität mindestens eines Rückanschlussleiters einer Rückleitung für den Bahnstrom eines Bahnenergieversorgungssystem für Gleichstrombahnen mit folgenden Verfahrensschritten:
Einspeisen eines Überwachungs-Wechselstroms in einen Stromkreis, der den mindestens einen Rückanschlussleiter (6) umfasst,
Vorsehen mindestens eines Sensors (11) zur Erfassung eines in dem mindestens einen Rückleitungsanschlussleiter (6) fließenden Stroms,
Überprüfen, ob Transienten eines in dem mindestens einen Rückleitungsanschlussleiter (6) fließenden Betriebsstroms einen vorgegebenen Grenzwert überschreiten, und
Überprüfen, ob ein in dem mindestens einen Rückleitungsanschlussleiter (6) fließender Überwachungs-Wechselstrom einen vorgegebenen Grenzwert überschreitet,
wobei auf einen Verlust eines Rückleitungsanschlussleiters (6) oder einen fehlerhaften Rückleitungsanschlussleiter geschlossen wird, wenn weder Transienten des Betriebsstroms einen vorgegebenen Grenzwert überschreiten noch der Überwachungs-Wechselstrom einen vorgegebenen Grenzwert überschreitet.

12. Verfahren nach Anspruch 11, **dadurch gekennzeichnet**, in einem ersten Schritt, wenn ein Überwachungs-Wechselstrom nicht eingespeist wird, überprüft wird, ob Transienten eines in dem mindestens einen Rückleitungsanschlussleiter (6) fließenden Betriebsstroms einen vorgegebenen Grenzwert überschreiten, wobei auf eine Integrität des mindestens einen Rückleitungsanschlussleiters geschlossen wird, wenn Transienten des Betriebsstroms einen vorgegebenen Grenzwert überschreiten.

13. Verfahren nach Anspruch 12, **dadurch gekennzeichnet, dass** in einem zweiten Schritt, wenn ein Überwachungs-Wechselstrom eingespeist wird, überprüft wird, ob ein in dem mindestens einen Rückleitungsanschlussleiter (6) fließender Überwachungs-Wechselstrom einen vorgegebenen Grenzwert überschreitet, wenn nach Ablauf eines vorgegebenen Zeitintervalls in dem ersten Schritt, wenn ein Überwachungsstrom nicht eingespeist worden ist, Transienten eines in dem mindestens einen Rückleitungsanschlussleiter (6) fließenden Betriebsstroms einen vorgegebenen Grenzwert nicht überschritten haben, wobei auf eine Integrität des mindestens einen Rückleitungsanschlussleiters (6) geschlossen wird, wenn der in dem mindestens einen Rückleitungsanschlussleiter (6) fließende Überwachungs-Wechselstrom einen vorgegebenen Grenzwert überschreitet und/oder auf einen Verlust eines Rückleitungsanschlussleiters (6) oder einen fehlerhaften Rückleitungsanschlussleiter geschlossen wird, wenn der in dem mindestens einen Rückleitungsanschlussleiter (6) fließende Überwachungs-Wechselstrom einen vorgegebenen Grenzwert nicht überschreitet.

14. Verfahren nach Anspruch 13, **dadurch gekennzeichnet, dass** wieder in dem ersten Schritt, wenn ein Überwachungs-Wechselstrom nicht eingespeist wird, überprüft wird, ob Transienten eines Betriebsstroms einen vorgegebenen Grenzwert überschreiten, wenn der in dem mindestens einen Rückleitungsanschlussleiter (6) fließende Überwachungs-Wechselstrom in dem zweiten Schritt einen vorgegebenen Grenzwert überschritten hat.

15. Verfahren nach einem der Ansprüche 11 bis 14, **dadurch gekennzeichnet, dass** das Bahnenergieversorgungssystem aufweist:
ein Unterwerk, das eine Traktionsenergiequelle (4), eine mit der Traktionsenergiequelle (4) elektrisch verbundene Rückleitersammelschiene (3) und eine Erdungsschiene (9), die mit einer Erdungsanlage (16) elektrisch verbunden ist, umfasst, so dass eine elektrische Ableitung (14) zum Erdreich geschaffen wird,
eine Rückleitung für den Bahnrückstrom, welche mindestens einen die Rückleitersammelschiene (3) mit einer Schienenrückleitung (1) elektrisch verbindenden Rückleitungsanschlussleiter (6) umfasst, wobei die Schienenrückleitung eine elektrische Ableitung (13) zum Erdreich (15) hat,
**dadurch gekennzeichnet, dass** ein Überwachungs-Wechselstrom in einen Stromkreis
eingespeist wird, welcher die Erdungsschiene (9), die Erdungsanlage (16) und deren
Ableitung(14) zum Erdreich (15), die Schienenrückleitung (1) und deren Ableitung (13) zum Erdreich (15), den mindestens einen Rückleitungsanschlussleiter (6) und die Rückleitersammelschiene (3) umfasst.

## Claims

1. Railway energy supply system for direct current railways, comprising
a substation comprising a traction energy source (4) and a return conductor busbar (3) electrically connected to the traction energy source (4),
a return line for the railway return current, which line comprises at least one return line connection conductor (6) electrically connecting the return conductor busbar (3) to a rail return line (1), and
a monitoring apparatus for monitoring the integrity of at least one return line connection conductor (6),
the monitoring apparatus comprising:
a current feed device (2) which is designed in such a way that a monitoring alternating current is fed which flows in the at least one return line connection conductor (6),
at least one sensor (11) for detecting a current flowing in the at least one return line connection conductor (6) and an evaluation and control device (10) that evaluates the signal of the at least one sensor and controls the current feed device (2),
**characterised in that**
the evaluation and control device is configured in such a way that the at least one sensor (11) can be used to check whether transients of an operating current flowing in the at least one return line connection conductor (6) exceed a predetermined limit value, or the at least one sensor (11) can be used to check whether a monitoring alternating current flowing in the at least one return line connection conductor (6) exceeds a predetermined limit value, with a loss of a return line connection conductor (6) or a faulty return line connection conductor being inferred if neither transients of the operating current nor the monitoring alternating current exceed a predetermined limit value.

2. Railway energy supply system according to claim 1, **characterised in that** the evaluation and control device (10) has a control unit (10a) for switching the current feed device (2) on and off, the evaluation and control device (10) being configured in such a way that in a first step, with the current feed device (2) switched off, it is checked whether transients of an operating current flowing in the at least one return line connection conductor (6) exceed a predetermined limit value, the integrity of the at least one return line connection conductor being inferred if the sensor (11) detects transients of an operating current that are greater than a predetermined limit value.

3. Railway energy supply system according to claim 2, **characterised in that** the evaluation and control device (10) has a timer (10b), the evaluation and control device (10) being configured in such a way that in a second step, with the current feed device (2) switched on, it is checked whether a monitoring alternating current flowing in the at least one return line connection conductor (6) exceeds a predetermined limit value if, after the timer has expired in the first step with the current feed device (2) switched off, transients of an operating current flowing in the at least one return line connection conductor (6) do not exceed the predetermined limit value.

4. Railway energy supply system according to claim 3, **characterised in that** the evaluation and control device (10) is configured in such a way that the integrity of the at least one return line connection conductor (6) is inferred if the monitoring alternating current flowing in the return line connection conductor (6) exceeds a predetermined limit value.

5. Railway energy supply system according to claim 4, **characterised in that** the evaluation and control device (10) is configured in such a way that the current feed device (2) is switched off again and, when the current feed device (2) is switched off, it is checked again whether transients of an operating current exceed a predetermined limit value if the monitoring alternating current flowing in the at least one return line connection conductor (6) exceeds the predetermined limit value.

6. Railway energy supply system according to claim 3, **characterised in that** the evaluation and control device (10) is configured in such a way that a loss of the at least one return line connection conductor or a faulty return line connection conductor is inferred if the monitoring alternating current flowing in the return line connection conductor (6) does not exceed a predetermined limit value.

7. Railway energy supply system according to any of claims 1 to 6, **characterised in that** the evaluation and control device (10) has a device (10c) for generating a control or alarm signal, the evaluation and control device (10) being designed in such a way that a control or alarm signal is generated when neither transients of the operating current exceed a predetermined limit value nor the monitoring alternating current exceeds a predetermined limit value.

8. Railway energy supply system according to any of claims 1 to 7, **characterised in that** the substation comprises an earthing bar (9) which is electrically connected to an earthing system (16), so that an electrical discharge line (14) to the ground (15) is created, the rail return line (1) having an electrical discharge line (13) to the ground (15), and **in that** the current feed device (2) is connected between the return conductor busbar (3) and the earthing rail (9) of the energy supply system, a first connection of the current feed device (2) being electrically connected to the return conductor busbar (3) and a second connection of the current feed device (2) being electrically connected to the earthing bar (9), so that a monitoring alternating current flows in a circuit which comprises the earthing rail (9), the earthing system (16) and the discharge line (14) thereof to the ground (15), the rail return line (1) and the discharge line (13) thereof to the ground (15), the at least one return line connection conductor (6) and the return conductor busbar (3).

9. Railway energy supply system according to claim 8, **characterised in that** a diode (7) is connected upstream or downstream of the current feed device (2).

10. Railway energy supply system according to any of claims 1 to 9, **characterised in that** the sensors (11) for detecting a current flowing in the at least one return line connection conductor (6) are inductive sensors without a magnetic core.

11. Method for monitoring the integrity of at least one return conductor of a return line for the railway current of a railway energy supply system for direct current railways, comprising the following method steps:
feeding a monitoring alternating current into a circuit that comprises the at least one return connection conductor (6),
providing at least one sensor (11) for detecting a current flowing in the at least one return line connection conductor (6),
checking whether transients of an operating current flowing in the at least one return line connection conductor (6) exceed a predetermined limit value, and
checking whether a monitoring alternating current flowing in the at least one return line connection conductor (6) exceeds a predetermined limit value,
wherein a loss of a return line connection conductor (6) or a faulty return line connection conductor is inferred if neither transients in the operating current exceed a predetermined limit value nor the monitoring alternating current exceeds a predetermined limit value.

12. Method according to claim 11, **characterised in that** in a first step, if a monitoring alternating current is not fed, it is checked whether transients of an operating current flowing in the at least one return line connection conductor (6) exceed a predetermined limit value, with an integrity of the at least one return line connection conductor being inferred when transients of the operating current exceed a predetermined limit value.

13. Method according to claim 12, **characterised in that** in a second step, when a monitoring alternating current is fed, it is checked whether a monitoring alternating current flowing in the at least one return line connection conductor (6) exceeds a predetermined limit value if after a predetermined time interval has elapsed in the first step, if a monitoring current has not been fed, transients of an operating current flowing in the at least one return line connection conductor (6) have not exceeded a predetermined limit value, with an integrity of the at least one return line connection conductor (6) being inferred if the monitoring alternating current flowing in the at least one return line connection conductor (6) exceeds a predetermined limit value and/or a loss of a return line connection conductor (6) or a faulty return line connection conductor being inferred if the monitoring alternating current flowing through the return line connection conductor (6) does not exceed a predetermined limit value.

14. Method according to claim 13, **characterised in that** again in the first step, if a monitoring alternating current is not fed, it is checked whether transients of an operating current exceed a predetermined limit value if the monitoring alternating current flowing in the at least one return line connection conductor (6) has exceeded a predetermined limit value in the second step.

15. Method according to any of claims 11 to 14, **characterised in that** the railway energy supply system comprises:
a substation, which comprises a traction energy source (4), a return conductor busbar (3) electrically connected to the traction energy source (4), and an earthing bar (9) which is electrically connected to an earthing system (16), thus producing an electrical discharge line (14) to the ground, a return line for the railway return current, which line comprises at least one return line connection conductor (6) electrically connecting the return conductor busbar (3) to a rail return line (1), the rail return line having an electrical discharge line (13) to the ground (15),
**characterised in that** a monitoring alternating current is fed into a circuit which connects the earthing rail (9), the earthing system (16) and the discharge line (14) thereof to the ground (15), the rail return line (1) and the discharge line (13) thereof to the ground (15), the at least one return line connection conductor (6) and the return conductor busbar (3).

## Revendications

1. Système d'alimentation électrique ferroviaire pour des chemins de fer à courant continu présentant
une sous-station qui comporte une source d'énergie de traction (4) et un rail de collecte de conducteur de retour (3) relié électriquement à la source d'énergie de traction (4),
une connexion de retour pour le courant de retour qui comporte au moins un conducteur de liaison de retour (6) reliant électriquement le rail de collecte de conducteur de retour (3) à une connexion de retour de rail (1), et
un dispositif de surveillance pour la surveillance de l'intégrité d'au moins un conducteur de liaison de retour (6),
dans lequel le dispositif de surveillance présente :
un dispositif d'alimentation en courant (2) qui est réalisé de telle manière qu'un courant alternatif de surveillance soit alimenté, lequel circule dans l'au moins un conducteur de liaison de retour (6),
au moins un capteur (11) pour la détection d'un courant circulant dans l'au moins un conducteur de liaison de retour (6) et un dispositif d'évaluation et de commande (10) commandant le dispositif d'alimentation en courant (2) et évaluant le signal d'au moins un capteur,
**caractérisé en ce que**
le dispositif d'évaluation et de commande est configuré de telle manière qu'avec l'au moins un capteur (11), il puisse être vérifié si des transitoires d'un courant de fonctionnement circulant dans l'au moins un conducteur de liaison de retour (6) dépassent une valeur limite prédéfinie, ou avec l'au moins un capteur (11), il puisse être vérifié si un courant alternatif de surveillance circulant dans l'au moins un conducteur de liaison de retour (6) dépasse une valeur limite prédéfinie, ce grâce à quoi il est conclu à une perte d'un conducteur de liaison de retour (6) ou à un conducteur de liaison de retour défectueux lorsque ni des transitoires du courant de fonctionnement ni le courant alternatif de surveillance ne dépassent une valeur limite prédéfinie.

2. Système d'alimentation électrique ferroviaire selon la revendication 1, **caractérisé en ce que** le dispositif d'évaluation et de commande (10) présente une unité de commande (10a) pour la mise en et hors service du dispositif d'alimentation en courant (2), dans lequel le dispositif d'évaluation et de commande (10) est configuré de telle manière que dans une première étape en cas de dispositif d'alimentation en courant mis hors service (2), il est vérifié si des transitoires d'un courant de fonctionnement circulant dans l'au moins un conducteur de liaison de retour (6) dépassent une valeur limite prédéfinie, sachant qu'il est conclu à une intégrité d'au moins un conducteur de liaison de retour lorsqu'avec le capteur (11), des transitoires d'un courant de fonctionnement qui sont supérieures à une valeur limite prédéfinie, sont détectées.

3. Système d'alimentation électrique ferroviaire selon la revendication 2, **caractérisé en ce que** le dispositif d'évaluation et de commande (10) présente un temporisateur (10b), le dispositif d'évaluation et de commande (10) étant configuré de telle manière que dans une seconde étape en cas de dispositif d'alimentation en courant (2) mis en service, il est vérifié si un courant alternatif de surveillance circulant dans l'au moins un conducteur de liaison de retour (6) dépasse une valeur limite prédéfinie lorsqu'à l'expiration du temporisateur dans la première étape en cas de dispositif d'alimentation en courant (2) mis hors service, des transitoires d'un courant de fonctionnement circulant dans l'au moins un conducteur de liaison de retour (6) ne dépassent pas la valeur limite prédéfinie.

4. Système d'alimentation électrique ferroviaire selon la revendication 3, **caractérisé en ce que** le dispositif d'évaluation et de commande (10) est configuré de telle manière qu'il soit conclu à une intégrité d'au moins un conducteur de liaison de retour (6) lorsque le courant alternatif de surveillance circulant dans le conducteur de liaison de retour (6) dépasse une valeur limite prédéfinie.

5. Système d'alimentation électrique ferroviaire selon la revendication 4, **caractérisé en ce que** le dispositif d'évaluation et de commande (10) est configuré de telle manière que le dispositif d'alimentation en courant (2) soit de nouveau mis hors service et en cas de dispositif d'alimentation en courant mis hors service (2), il soit de nouveau vérifié si des transitoires d'un courant de fonctionnement dépassent une valeur limite prédéfinie lorsque le courant alternatif de surveillance circulant dans l'au moins un conducteur de liaison de retour (6) dépasse la valeur limite prédéfinie.

6. Système d'alimentation électrique ferroviaire selon la revendication 3, **caractérisé en ce que** le dispositif d'évaluation et de commande (10) est configuré de telle manière qu'il soit conclu à une perte d'au moins un conducteur de liaison de retour ou un conducteur de liaison de retour défectueux lorsque le courant alternatif de surveillance circulant dans le conducteur de liaison de retour (6) ne dépasse pas une valeur limite prédéfinie.

7. Système d'alimentation électrique ferroviaire selon l'une quelconque des revendications 1 à 6, **caractérisé en ce que** le dispositif d'évaluation et de commande (10) présente un dispositif (10c) pour la génération d'un signal de commande ou de signalisation, dans lequel le dispositif d'évaluation et de commande (10) est réalisé de telle manière qu'un signal de commande ou de signalisation soit généré lorsque ni des transitoires du courant de fonctionnement dépassent une valeur limite prédéfinie ni le courant alternatif de surveillance dépasse une valeur limite prédéfinie.

8. Système d'alimentation électrique ferroviaire selon l'une quelconque des revendications 1 à 7, **caractérisé en ce que** la sous-station comporte une barre de masse (9) qui est électriquement reliée à une installation de masse (16) de sorte qu'une dérivation (14) électrique à la terre (15) soit créée, dans lequel la connexion de retour de rail (1) présente une dérivation (13) électrique à la terre (15),
et que le dispositif d'alimentation en courant (2) est monté entre le rail de collecte de conducteur de retour (3) et la barre de masse (9) de l'installation d'alimentation en énergie, dans lequel une première borne du dispositif d'alimentation en courant (2) est électriquement reliée au rail de collecte de conducteur de retour (3) et une seconde borne du dispositif d'alimentation en courant (2) est électriquement reliée à la barre de masse (9), de sorte qu'un courant alternatif de surveillance circule dans un circuit électrique qui comporte la barre de masse (9), l'installation de masse (16) et sa dérivation (14) à la terre (15), la connexion de retour de rail (1) et sa dérivation (13) à la terre (15), l'au moins un conducteur de liaison de retour (6) et le rail de collecte de conducteur de retour (3).

9. Système d'alimentation électrique ferroviaire selon la revendication 8, **caractérisé en ce qu'**une diode (7) est montée en amont ou en aval du dispositif d'alimentation en courant (2).

10. Système d'alimentation électrique ferroviaire selon l'une quelconque des revendications 1 à 9, **caractérisé en ce que** les capteurs (11) sont des capteurs inductifs pour la détection d'un courant circulant dans l'au moins un conducteur de liaison de retour (6) sans noyau magnétique.

11. Procédé de surveillance de l'intégrité au moins d'un conducteur de raccordement de retour d'une connexion de retour pour le courant d'un système d'alimentation électrique ferroviaire pour des chemins de fer à courant continu avec les étapes de procédé suivantes :
alimenter un courant alternatif de surveillance dans un circuit électrique qui comporte l'au moins un conducteur de raccordement de retour (6),
prévoir au moins un capteur (11) pour la détection d'un courant circulant dans l'au moins un conducteur de liaison de retour (6),
vérifier si des transitoires d'un courant de fonctionnement circulant dans l'au moins un conducteur de liaison de retour (6) dépassent une valeur limite prédéfinie, et
vérifier si un courant alternatif de surveillance circulant dans l'au moins un conducteur de liaison de retour (6) dépasse une valeur limite prédéfinie,
dans lequel il est conclu à une perte d'un conducteur de liaison de retour (6) ou à un conducteur de liaison de retour défectueux lorsque ni des transitoires du courant de fonctionnement ne dépassent une valeur limite prédéfinie ni le courant alternatif de surveillance ne dépasse une valeur limite prédéfinie.

12. Procédé selon la revendication 11, **caractérisé en ce que** dans une première étape lorsqu'un courant alternatif de surveillance n'est pas alimenté, il est vérifié si des transitoires d'un courant de fonctionnement circulant dans l'au moins un conducteur de liaison de retour (6) dépassent une valeur limite prédéfinie, dans lequel il est conclu à une intégrité d'au moins un conducteur de liaison de retour lorsque des transitoires du courant de fonctionnement dépassent une valeur limite prédéfinie.

13. Procédé selon la revendication 12, **caractérisé en ce que** dans une seconde étape, lorsqu'un courant alternatif de surveillance est alimenté, il est vérifié si un courant alternatif de surveillance circulant dans l'au moins un conducteur de liaison de retour (6) dépasse une valeur limite prédéfinie lorsqu'à expiration d'un intervalle de temps prédéfini dans la première étape lorsqu'un courant de surveillance n'a pas été alimenté, des transitoires d'un courant de fonctionnement circulant dans l'au moins un conducteur de liaison de retour (6) n'ont pas dépassé une valeur limite prédéfinie, dans lequel il est conclu à une intégrité d'au moins un conducteur de liaison de retour (6) lorsque le courant alternatif de surveillance circulant dans l'au moins un conducteur de liaison de retour (6) dépasse une valeur limite prédéfinie et/ou il est conclu à une perte d'un conducteur de liaison de retour (6) ou à un conducteur de liaison de retour défectueux lorsque le courant alternatif de surveillance circulant dans l'au moins un conducteur de liaison de retour (6) ne dépasse pas une valeur limite prédéfinie.

14. Procédé selon la revendication 13, **caractérisé en ce que** de nouveau dans la première étape lorsqu'un courant alternatif de surveillance n'est pas alimenté, il est vérifié si des transitoires d'un courant de fonctionnement dépassent une valeur limite prédéfinie, lorsque le courant alternatif de surveillance circulant dans l'au moins un conducteur de liaison de retour (6) a dépassé dans la seconde étape une valeur limite prédéfinie.

15. Procédé selon l'une quelconque des revendications 11 à 14, **caractérisé en ce que** le système d'alimentation électrique ferroviaire présente :
une sous-station qui comporte une source d'énergie de traction (4), un rail de collecte de conducteur de retour (3) relié électriquement à la source d'énergie de traction (4) et une barre de masse (9) qui est électriquement reliée à une installation de masse (16) de sorte qu'une dérivation (14) électrique à la terre soit créée,
une connexion de retour pour le courant de retour qui comporte au moins un conducteur de liaison de retour (6) reliant électriquement le rail de collecte de conducteur de retour (3) à une connexion de retour de rail (1), dans lequel la connexion de retour de rail présente une dérivation (13) électrique à la terre (15), **caractérisé en ce qu'**un courant alternatif de surveillance est alimenté dans un circuit électrique qui comporte la barre de masse (9), l'installation de masse (16) et sa dérivation (14) à la terre (15), la connexion de retour de rail (1) et sa dérivation (13) à la terre (15), l'au moins un conducteur de liaison de retour (6) et le rail de collecte de conducteur de retour (3).
